Europäisches Patentamt

European Patent Office

Office européen des brevets

(11) Publication number: **0 445 309 A1**

# EUROPEAN PATENT APPLICATION

(21) Application number: **90102499.2**

(22) Date of filing: **08.02.90**

(51) Int. Cl.⁵: **H01L 23/473**, H01L 23/467

(43) Date of publication of application:
**11.09.91 Bulletin 91/37**

(84) Designated Contracting States:
**DE FR GB**

(71) Applicant: **Microelectronics and Computer Technology Corporation**
**3500 West Balcones Center Drive**
**Austin Texas 78757(US)**

(72) Inventor: **Nelson, Richard Douglas**
**16701 Westview Trail**
**Austin, Texas 78737(US)**
Inventor: **Gupta, Omkarnath Ramnath**
**44873 Lynx Drive**
**Fremont, California 94539(US)**
Inventor: **Herrell, Dennis J.**
**6605 Serena Cove**
**Austin, Texas 78730(US)**

(74) Representative: **Henkel, Feiler, Hänzel & Partner**
**Möhlstrasse 37**
**W-8000 München 80(DE)**

(54) **Fluid heat exchanger for an electronic component.**

(57) A high performance fluid heat exchanger (10) for cooling an electronic component (16) which includes housing (12) having a base (14), a plurality of parallel fins (22) in the housing (12), and a center fed inlet (30) connected to the housing (12) opposite the base (14) for supplying cooling fluid towards the base (14) and toward the ends of the fins (28). A plate (36) is positioned between the tops (24) and bottom (26) of the fins (22) and extends generally parallel to the base (14) and extends towards, but is spaced from, the ends of the fins (28) for providing a double cooling pass against the fins.

Fig. 1

## FLUID HEAT EXCHANGER FOR AN ELECTRONIC COMPONENT

Background of the invention

Liquid cooling heat exchangers for cooling electronic components are in use to cool high power electronic chips. Greater heat transfer and maximum power density can be provided by using finned heat exchange surfaces.

The present invention is directed to an improved high performance heat exchanger for cooling electronic components, such as chips, by providing a double fluid pass against the fins along their length. The present heat exchanger balances thermal resistance, spatial temperature variations, pressure drops, and space requirements. The present invention is particularly useful for an electronic component having even power distribution over its surface as the present heat exchanger will provide a more even temperature distribution from its base.

The present invention is directed to a center fed fluid heat exchanger for cooling an electronic component and includes a housing having a base for receiving heat from an electronic component. A plurality of spaced fins, preferably parallel to each other, each having a top, bottom, and two ends are provided with the bottoms connected to the base in which the fins are perpendicular to the base. A first fluid connection, such as a fluid inlet tube communicates with the housing opposite the base and has a longitudinal axis perpendicular to the base. The axis is directed towards the fins between the ends of the fins for transmitting a cooling fluid between the inlet tube and the fins, the base and the ends of the fins. A second fluid connection, such as a fluid outlet tube is in communication with the ends of the fins. The tops of the fins include a recess in communication with the inlet tube for supplying fluid to all of the fins. A plate is provided between the top and bottom of the fins extending generally parallel to the base and extending toward but spaced from the ends of the fins for directing the cooling fluid in a double pass relationship along the length of the fins.

The present invention relates to a structure wherein the longitudinal axes of the tubes are directed to the center of the base for increasing the heat transfer by the cooling fluid in the center of the electronic component since the center tends to be hotter than other areas.

Further, the tops of the fins include a recess in communication with the inlet tube for supplying cooling fluid to all of the fins.

Still further, a plate is provided on the tops of the fins on opposite sides of the inlet tube for directing inlet cooling fluid from the inlet tube towards both ends of the fins. The housing includes a passageway extending from the ends of the fins to the outlet tube.

The ends of the fins are tapered downwardly and outwardly from the tops to the bottoms for decreasing the pressure drop and heat transfer at the ends of the fins.

The inlet tube is positioned adjacent the tops of the fins for impinging cooling fluid onto the fins and the base.

The plate is positioned midway between the top and bottom of the fins for minimizing pressure drop, and the ends of the fins extend to the inside of the housing for maximum heat transfer. The inlet and outlet are concentric tubes.

The present invention also provides structural interconnections between the fins and the plate for ease of assembly and structurally connecting the parts of the heat exchanger.

Other objects, features and advantages will be apparent from the following description of presently preferred embodiments of the invention and taken in conjunction with the accompanying drawing, wherein: -

Fig. 1    is an elevational view, in cross-section, of one embodiment of the present invention;

Fig. 2    is an enlarged perspective view of the fin structure inside of the apparatus of Fig. 1;

Fig. 3    is a fragmentary elevational view, in cross-section, of another embodiment of the present invention;

Fig. 4    is an elevational view, in cross-section, of still another embodiment of the present invention; and

Fig. 5    is a perspective view of the finned structure inside the apparatus of Fig. 4.

Description of Preferred Embodiments

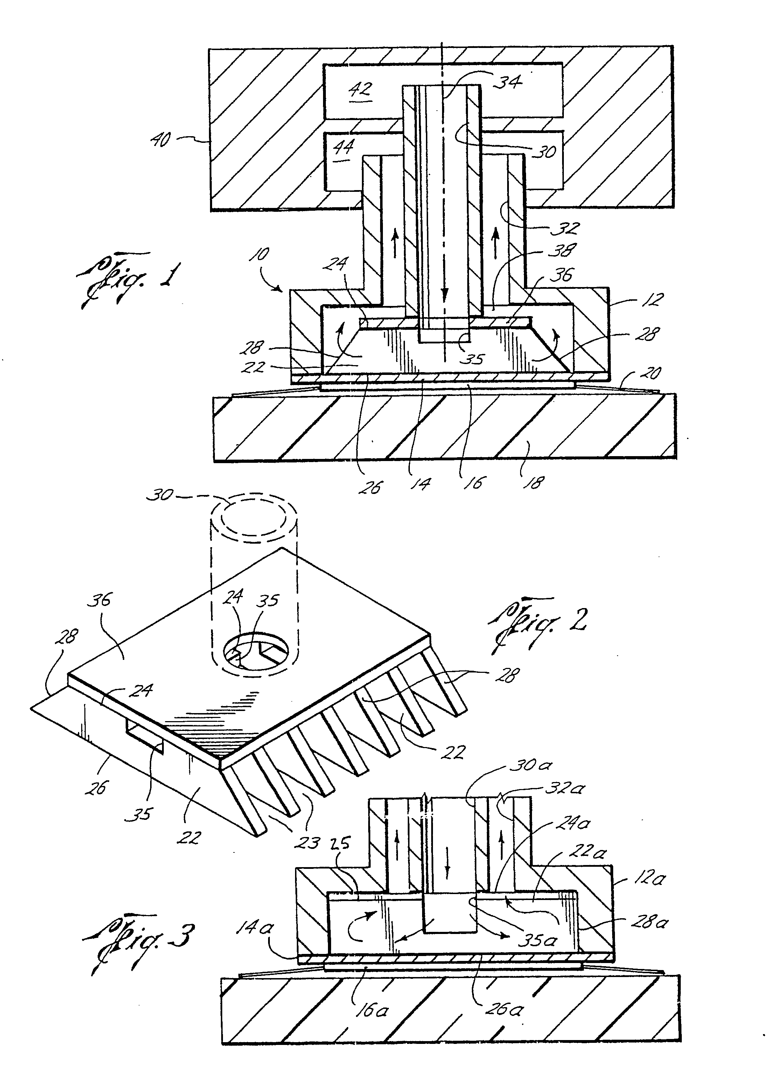

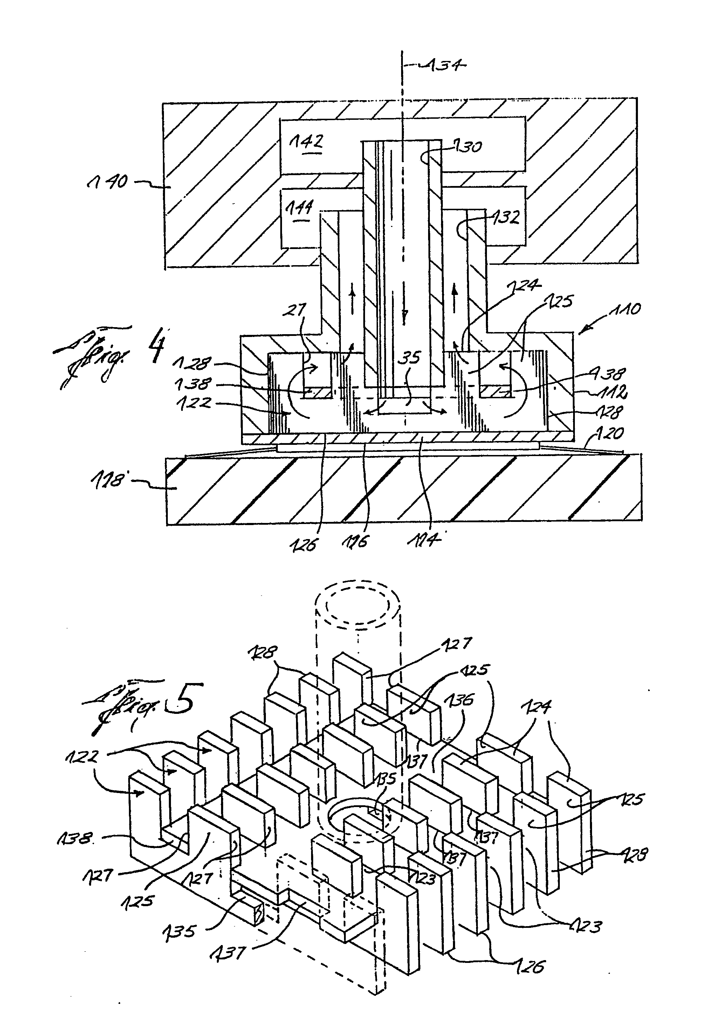

Referring now to the drawings, and particularly to Figs. 1 and 2, the reference numeral 10 generally indicates the fluid heat exchanger of the present invention. While any suitable cooling fluid can be such as a gas or liquid, the present invention will be described for the purpose of illustration only, as using water. The apparatus 10 includes a housing 12 having a base 14. The base 14 is adapted to be part of or attached to an electronic component 16 such as an electronic chip which may be connected to a substrate 18 by suitable electrical connections 20. In any event, the base 14 is positioned relative to the chip 16 for receiving heat therefrom.

A plurality of parallel spaced fins 22 are provided. Each of the fins 22 includes a top 24, a bottom 26 and ends 28. The bottoms 26 of the fins 22 are connected to or made integral with the base 14 and the fins are positioned in planes perpendicular to the base 14. Concentric inner fluid inlet tube 30 and outer fluid outlet tube 32 are connected to the housing 12 opposite the base 14 and have a longitudinal axis 34 directed towards the fins 22 between the ends 28 of the fins 22. Thus, incoming cooling liquid flows downwardly through the inlet tube 30, preferably to the center of the base 14, and in the channels 23 between the fins 22, and is then directed to both ends 28 of the fins 22. Splitting the flow of the center fed cooling liquid results in lower pressure drops across the fins 22.

The cross-sectional area of the inlet 30 and outlet 32 tubes is less than the cross-sectional area of the base 14. In order to supply cooling fluid to the channels 23 between the fins 22 which are not directly under the outlet end of the inlet tube 30, a recess 35 is provided in the tops 24 of the fins 22 for supplying cooling fluid to all of the fins 22.

Preferably, plate 36 is provided on the tops 24 of the fins 22 around the inlet tube 30 for insuring that the fluid flow of the cooling liquid passes from the centers of the fins 22 to both ends 28 of the fins 22 for maximum cooling. A passageway 38 is provided in the housing from the channels 23, over the tops of the plate 36, and into communication with the outlet tube 32.

The center of the electronic component 16 is normally the hotter area. It is to be noted that the incoming flow through the inlet tube 30 is directed towards the center of the heat exchanger 12 for cooling this hotter area. It is also to be noted that the liquid velocity is higher in the center of the heat exchanger 12 because of the position of the inlet tube 30. The present invention provides control of the spatial temperature variations across the face of the chip 16 by adjusting the shape and size of the recess 35 to provide more fluid flow at the center and tailor the flow elsewhere to maintain approximately uniform temperatures. While the recess is shown generally rectangular, it may be other shapes, such as triangular, and is sized to provide both optimum temperature profiles and low pressure drops.

It is further noted that the inlet tube 30 is positioned adjacent the tops 24 of the fins 22 causing the inlet cooling fluid to impinge on the fins 22 and the base 14. The impingement of the cooling fluid on the base 14 in a perpendicular direction creates a non-steady flow phenomenon against the base 14 and the sides of the fins 22 increasing the heat transfer coefficient in the center of the housing 12 and chip 16.

Preferably, the ends 28 of the fins 22 are tapered down-wardly and outwardly from the tops 24 to the bottoms 26 for decreasing the pressure drop and lowering the heat transfer at the ends of the fins. The heat transfer at the fins 22 is a function of the width of the channels 23 between the fins, the fin thickness and fin height. In a preferred embodiment for the application to chip power densities of 50 to 100 watts/square centimeter, copper fins 2,54 mm (0.1 inch) high by 0,25 - 0,50 mm (0.010 to 0.020 inch) thick could be used with channel spacings of 0,25 - 0,50 mm (0.010 to 0.020 inch). It has been calculated that the present invention will provide a heat exchanger thermal resistance of about 0.2 $kW/cm^2$, spatial temperature variations at 100 $W/cm^2$ of 10 K, pressure drop of about 0,28 bar (4 psi), and a package height of about 12,7 mm (half an inch).

In the embodiment of Fig. 1, a manifold 40 may be provided having an inlet fluid manifold 42 and an outlet fluid manifold 44 which would be particularly advantageous for a multichip package application. However, the inlet tube 30 and outlet tube 32 may be attached directly to hoses or other fluid conduits.

Another embodiment may be provided such as shown in Fig. 3 where like parts to those shown in Figs. 1 and 2 are similarly numbered with the addition of the suffix "a." In this embodiment, the top plate 36 is omitted in order to encourage the impingement phenomenon of the incoming cooling liquid at the center of the base 14a of the heat exchanger 12a. The structure of Fig. 3 also allows the exiting liquid to pass across the upper portions of the fins 22a as it moves towards the outlet tube 32a. This flow pattern functions as a two-pass heat exchanger which tends to equalize spatial temperature variations.

A further embodiment is illustrated in Figs. 4 and 5 wherein reference number 110 generally indicates a fluid heat exchanger of the present invention. While any suitable cooling fluid can be used such as a gas or liquid, the present invention will be described for the purpose of illustration only, as using water. The apparatus 110 includes a housing 112 having a base 114. The base 114 is adapted to be part of or attached to an electronic component 116, such as an electronic chip, which may be connected to a substrate 118 by suitable electrical connections 120. In any event, the base 114 is positioned relative to the chip 116 for receiving heat therefrom.

A plurality of spaced fins 122, preferably parallel to each other, are provided in the housing 112. Each of the fins 122 includes a top 124, a bottom 126 and ends 128. The bottoms 126 of the fins 122 are connected to or made integral with the base 114, and the fins 122 are positioned in planes perpendicular to the base 114. A first fluid tube such as an inlet tube 130 and a second fluid tube such as an outlet tube 132, preferably concentric, are connected to the housing 112 opposite the base 114 and have a longitudinal axis 134 directed towards the fins 122 between the ends 128 of the fins 122. Thus, incoming cooling liquid flows downwardly through the inlet tube 130, preferably to the center of the base 114, and in the channels 123 between the fins 122 and is then directed to both ends 128 of the fins 122. Splitting the flow of the center fed cooling liquid results in lower pressure drops across the fins 122.

The cross-sectional area of the inlet 130 and outlet 132 tubes is less than the cross-sectional area of the base 114. In order to supply cooling fluid to the channels 123 between the fins 122 which are not directly under the outlet end of the inlet tube 130, a recess 135 is provided in the tops 124 of the fins 122 in communication with the inlet 130 for supplying cooling fluid to all of the fins 122.

A plate 136 is provided between the tops 124 and the bottoms 126 of the fins 128. The plate extends generally parallel to the base 114 and extends towards, but is spaced from, the ends 128 of the fins 122. The plate 136 provides for a double pass of the cooling liquid along the length of the fins 122. That is, the incoming fluid through the inlet tube 130 is directed towards the center of the heat exchanger 112, through the recess 135 to all of the channels 123 between the fins 122. The fluid then flows towards the opposite ends 128 of the fins 122 making one pass along the length along the bottoms 126 of the fins 122. The liquid then flows around the ends 138 of the plate 136. The cooling liquid then flows inwardly from the ends 128 of the fins 122 making a second pass across the portions of the fins 122 which are above the plate 136, and exits through the fluid outlet 132. Of course, if desired the direction of the fluid flow could be reversed by directing the incoming fluid through tube 132 and exiting through tube 130.

The heat exchanger 110 is particularly advantageous where there is an even power distribution over the area of the chip 116. The present invention provides a more even temperature distribution out of the base 114. That is, the cooling liquid flowing from the inlet 130 is initially cooler as it flows downwardly into the middle of the base 114, warms as it passes towards the ends 128 of the fins 122, and becomes still warmer as it makes a second pass across the top portion of the fins 122 and reaches its highest temperature nearer the center and exits through the outlet 132. This generally provides a more even heat dissipation from the base 114 by each of the fins 122.

The plate 136 is preferably positioned midway between the tops 124 and the bottoms 126 of the fins 122 for providing an even pressure drop along the path of the fluid flow.

Preferably, the ends 128 of the fins 122 extend to the inside of the housing 112 for providing a maximum fin area for heat transfer. The heat transfer at the fins 122 is a function of the width of the channels 123 between the fins 122, the thickness of the fins 122 and the height of the fins 122. In the preferred embodiment, copper fins 0.1 inches (2,54 mm) high by 2,54 - 0,50 mm (0.10 to 0.020 inches) thick can be used with channel spacings of 0,25 - 0,50 mm (0.010 to 0.020 inches).

Preferably, the ends 128 of the fins 122 extend to and are in contact with the inside of the walls of the housing 112 for providing a maximum heat transfer from the base 114. However, if desired, the ends 128 of the fins 122 can be tapered downwardly and outwardly for decreasing the pressure drop of the cooling liquid.

In the embodiment shown, a manifold 140 may be provided having an inlet fluid manifold 142 and an outlet fluid manifold 144 which would be particularly advantageous for a multi-chip package application. However, the inlet tube 130 and the outlet tube 132 may be attached directly to hoses or other fluid conduits.

Preferably for ease of assembly and for structurally interconnecting the fins 122 and the plate 136, the fins and plate are provided with coacting engaging parts. Thus, the fins 122 include a plurality of upwardly directed projections 125 separated by recesses 127. The plate 136 includes a plurality of spaced openings 137 for receiving the projections 125. The heat exchanger 110 can easily and quickly be assembled by inserting the projections 125 into the openings 137 thereby interconnecting the fins 22 with the plate 136 and providing structural support therebetween.

The present invention, therefore, is well adapted to carry out the objects and attain the ends and advantages mentioned as well as others inherent therein.

## Claims

1. A fluid heat exchanger for cooling an electronic component comprising,

   a housing having a base for receiving heat from an electronic component,

   a plurality of parallel spaced fins each having a top, bottom, and two ends, said bottoms connected to the base, said fins being perpendicular to the base,

   the ends of the fins being tapered downwardly and outwardly from the tops to the bottoms for decreasing the pressure drop, and heat transfer to the ends of the fins,

a fluid inlet tube communicating with the housing opposite the base and having a longitudinal axis perpendicular to the base, said axis directed towards the fins between the ends of the fins for directing a cooling fluid from the inlet tube towards the fins and the base and towards the ends of the fins, and a fluid outlet in communication with the ends of the fins,

the tops of the fins include a recess in communication with the inlet tube for supplying cooling fluid to all of the fins, and

a plate on the tops of the fins extending from the inlet tube to the downward taper at the ends of the fins for directing cooling fluid from the inlet tube towards both ends of the fins while minimizing the pressure drops at the ends.

2. The apparatus of claim 1 wherein the cross-sectional areas of the inlet and outlet tubes are less than the cross-sectional area of the base, and the longitudinal axis of the tubes is directed to the center of the base.

3. A fluid heat exchanger for cooling an electronic component comprising,

a housing having a base for receiving heat from an electronic component,

a plurality of spaced fins each having a top, bottom, and two ends, said bottoms connected to the base, and said fins being perpendicular to the base,

a first fluid tube communicating with the housing opposite the base and having a longitudinal axis perpendicular to the base, said axis directed towards the fins between the ends of the fins for transmitting a cooling fluid between the first tube and the fins, the base and the ends of the fins, and a second fluid tube in communication with the fins,

the tops of the fins including a recess in communication with the first tube for communicating fluid between all of the fins and the first tube, and

a plate between the top and bottom of the fins extending generally parallel to the base and extending toward but spaced from the ends of the fins for directing the cooling fluid in a double pass against the fins.

4. The apparatus of claim 3 wherein the plate is positioned midway between the tops and bottoms of the fins.

5. The apparatus of claim 3 wherein the ends of the fins extend to the inside of the housing.

6. The apparatus of claim 3 wherein the first fluid tube and the second fluid tube are concentric tubes.

7. The apparatus of claim 3 wherein the top portions of each of the fins include a plurality of upwardly directed projections separated by recesses, and

said plate includes a plurality of spaced openings for receiving the projections of the fins for easily assembling and structurally connecting the fins to the plate.

*Fig. 1*

*Fig. 2*

*Fig. 3*

Fig. 4

Fig. 5

7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| E | US-A-4 909 315 (MICROELECTRONICS AND COMPUTER TECHNOLOGY) --- | 1-3,5,6 | H 01 L 23/473 H 01 L 23/467 |
| E | US-A-4 940 085 (MICROELECTRONICS AND COMPUTER TECHNOLOGY) --- | 3-7 | |
| Y | US-A-4 561 040 (IBM) * Column 4, line 52 - column 5, line 13; figures 1,2 * --- | 1-4,6 | |
| Y | EP-A-0 353 437 (MICROELECTRONICS AND COMPUTER TECHNOLOGY) * Page 3, column 4, lines 27-40; figure 1 * | 1,2 | |
| A | | 1,2 | |
| Y | WO-A-7 901 012 (GENERAL ELECTRIC CO.) * Page 9, lines 24-34; figure 3 * --- | 3,4,6 | |
| A | US-A-3 909 118 (TEXTRON INC.) * Column 4, lines 11-29; figure 4 * --- | 1-3,6 | TECHNICAL FIELDS SEARCHED (Int. Cl.5) |
| A | IBM TECHNICAL DISCLOSURE BULLETIN, vol. 32, no. 8A, January 1990, pages 168-170, Armonk, NY, US; "Buffered immersion cooling with buckling bellows providing barrier between chip and system coolant and pressure" * Whole document * --- | 1,3,5,6 | H 01 L 23/00 |
| A | US-A-4 882 654 (MICROELECTRONICS AND COMPUTER TECHNOLOGY) * Column 3, lines 14-27; figure 1 * ----- | 1-3,6 | |

The present search report has been drawn up for all claims

| Place of search | Date of completion of the search | Examiner |
|---|---|---|
| THE HAGUE | 08-10-1990 | ZEISLER P.W. |

EPO FORM 1503 03.82 (P0401)